(19) Europäisches Patentamt
European Patent Office
Office européen des brevets

(11) Veröffentlichungsnummer: **0 141 389**
**A2**

(12) # EUROPÄISCHE PATENTANMELDUNG

(21) Anmeldenummer: **84112932.3**

(51) Int. Cl.[4]: **G 03 F 7/02**

(22) Anmeldetag: **26.10.84**

(30) Priorität: **07.11.83 DE 3340154**

(43) Veröffentlichungstag der Anmeldung:
**15.05.85 Patentblatt 85/20**

(84) Benannte Vertragsstaaten:
**CH DE FR GB IT LI NL**

(71) Anmelder: **BASF Aktiengesellschaft**
**Carl-Bosch-Strasse 38**
**D-6700 Ludwigshafen(DE)**

(72) Erfinder: **Schupp, Hans, Dr.**
**10 Gartenweg**
**D-6706 Wachenheim(DE)**

(72) Erfinder: **Elzer, Albert, Dr.**
**4 Pappelstrasse**
**D-6701 Otterstadt(DE)**

(54) **Verfahren zur Herstellung von bildmässig strukturierten Resistschichten und für dieses Verfahren geeigneter Trockenfilmresists.**

(57) Bei der Herstellung von bildmäßig strukturierten Resistschichten beispielsweise für die Anwendung zur Herstellung von gedruckten Schaltungen, elektronischen Bauelementen, Lötstoppmasken etc., durch Aufbringen einer positiv arbeitenden, durch Bestrahlung mit aktinischem Licht löslich machbaren Resistschicht (R) auf ein Substrat, bildmäßiges Belichten der Resistschicht (R) mit aktinischem Licht und Entfernen der belichteten Schichtanteile durch Auswaschen mit einem Entwicklerlösungsmittel, wird - insbesondere in Form eines Trockenfilmresistes - eine lichtempfindliche Resistschicht (R) eingesetzt, die aus mindestens zwei Lagen (L) gebildet wird, die eine unterschiedliche Grundlöslichkeit besitzen, wobei zumindest die obere Lage (OL) lichtempfindlich ist und die untere Lage (UL) eine höhere Grundlöslichkeit in dem Entwicklerlösungsmittel besitzt als die obere Lage (OL).

EP 0 141 389 A2

# Verfahren zur Herstellung von bildmäßig strukturierten Resistschichten und für dieses Verfahren geeigneter Trockenfilmresists

Die Erfindung betrifft ein Verfahren zur Herstellung von bildmäßig strukturierten Resistschichten auf einem Substrat, wie z.B. Resistmustern oder Lötstoppmasken, bei dem eine auf das Substrat aufgebrachte, mehrlagige, positiv arbeitende, lichtempfindliche resistbildende Schicht bildmäßig mit aktinischem Licht belichtet wird und anschließend die belichteten Schichtanteile durch Auswaschen mit einem Entwicklerlösungsmittel entfernt werden. Die Erfindung betrifft des weiteren einen für den Einsatz in diesem Verfahren geeigneten Trockenfilmresist mit einer auf einem temporären Träger aufgebrachten, festen, mehrlagigen, positiv arbeitenden, lichtempfindlichen und unter Anwendung von Druck sowie gegebenenfalls Wärme auf ein Substrat übertragbaren, resistbildenden Schicht.

Positiv arbeitende, lichtempfindliche Aufzeichnungsmaterialien für die Herstellung von bildmäßig strukturierten Resistschichten, wie sie beispielsweise bei der Herstellung von Leiterbahnen, gedruckten Schaltungen, Dünnschichtschaltungen, elektronischen Bauelementen, Lötstoppmasken etc. zur Anwendung kommen können, sind in der Literatur mehrfach beschrieben. Gegenüber den negativ arbeitenden, photopolymerisierbaren oder photovernetzbaren Resistmaterialien und den positiv arbeitenden Aufzeichnungsmaterialien auf Basis von photopolymerisierbaren Systemen, die durch Bestrahlung mit aktinischem Licht desensibilisiert werden können und dadurch die Photopolymerisation in den so belichteten Bereichen unterdrückt werden kann, zeigen positiv arbeitende, lichtempfindliche Resistmaterialien, bei denen durch bildmäßige Belichtung die belichteten Bereiche in Lösungsmitteln löslich werden, in denen sie vorher unlöslich waren, für die Anwendung vielfach vorteilhafte Eigenschaften. So ist häufig das Auflösungsvermögen solcher positiv arbeitenden, durch Bestrahlung mit aktinischem Licht löslich machbaren Resistmaterialien verbessert, und hieraus hergestellte Resistschichten können mehrfach hintereinander bildmäßig belichtet und entwickelt werden, wobei nach jedem Entwicklungsschritt die hierbei jeweils freigelegte Oberfläche des Substrats in gewünschter, gegebenenfalls jeweils unterschiedlicher Weise modifiziert werden kann.

Positiv arbeitende, durch Bestrahlung mit aktinischem Licht löslich werdende Beschichtungsmaterialien und Trockenfilmresiste sind unter anderem in der DE-A-20 28 903, der DE-A-22 36 914, der US-A-3 782 939, der US-A-3 837 860 und der US-A-4 193 797 beschrieben. Die hieraus bekannten, positiv arbeitenden Resistmaterialien sind auf Basis von o-Chinondiazid-Gruppen enthaltenden Verbindungen aufgebaut, die bei Bestrahlung mit aktinischem Licht unter Bildung von alkalilöslichen Photolyseprodukten reagieren. Ein gewisser Nachteil dieser Resistmaterialien auf Basis von o-Chinondiazid-Verbindungen ist ihre relativ geringe Lagerstabilität und die nicht allzu große Beständigkeit gegenüber wäßrig-alkalischen Medien, was eine Einschränkung bei ihrer Verarbeitbarkeit und Verwendung mit sich bringt.

In der DE-C-21 50 691 sowie der DE-A-29 22 746 werden sehr vorteilhafte, positiv arbeitende, bei Bestrahlung mit aktinischem Licht löslich werdende Resistmaterialien bzw. Trockenfilmresiste beschrieben, deren lichtempfindliche Schicht auf Basis von o-Nitrocarbinolestergruppierungen enthaltenden Polymeren aufgebaut ist, die nach der Belichtung mit einem wäßrig--alkalischen Entwicklerlösungsmittel ausgewaschen werden können. Diese Resistmaterialien haben eine hohe Lagerstabilität, lassen sich einfach verarbeiten und erlauben eine Mehrfachbelichtung und -entwicklung der Resistschicht. Vorteilhafte Weiterentwicklungen dieser Resistmaterialien, insbesondere für spezielle Anwendungsbereiche, sowie Ausgestaltungen der Verfahren zu ihrer Verarbeitung sind in den älteren, nicht vorveröffentlichten Patentanmeldungen DE-A-32 31 147, DE-A 33 26 036 und DE-A-33 31 691 beschrieben.

Die in den vorstehend genannten Druckschriften beschriebenen Resistmaterialien und Trockenfilmresiste bestehen aus einer einheitlichen lichtempfindlichen Resistschicht. Ein Nachteil ist, daß diese Resistschichten vergleichsweise lange Belichtungszeiten benötigen. Im Hinblick auf eine schnelle und problemlose Verarbeitbarkeit ist es das Bestreben, die Belichtungszeiten so kurz wie möglich zu halten und dennoch zu einer exakten, originalgetreuen Reproduktion der Bildvorlage zu gelangen, die den an Resistschichten gestellten Anforderungen genügt.

In der EP-A-76 565 wird ein positiv und mit hoher Geschwindigkeit arbeitendes photopolymerisierbares Element für die Herstellung von Resistschichten beschrieben, bei dem eine härtbare Gelatine-Schicht mit einer üblichen, negativ arbeitenden photopolymerisierbaren Schicht überzogen wird. Nach bildmäßiger Bestrahlung der photopolymerisierbaren Schicht, bei der die bestrahlten Bereiche polymerisiert und vernetzt werden, läßt man durch diese Schicht einen Härter für die Gelatine-Schicht eindiffundieren, wobei die nicht bestrahlten Bereiche der photopolymeren Schicht den Härter leichter diffundieren lassen als die bestrahlten, photopolymerisierten Bereiche. Dadurch wird die Gelatine-Schicht bildmäßig gehärtet. Anschließend werden mit einem Entwicklerlösungsmittel die obere, photopolymere Schicht und die nicht gehärteten Bereiche der Gelatine-Schicht

entfernt, wodurch ein positives Bild entsteht. Auch wenn man bei diesen Resistmaterialien mit kurzen Belichtungszeiten auskommen kann, ist dieses Verfahren wegen der geringeren Differenzierung in den Diffusionseigenschaften sehr anfällig, erlaubt nur eine relativ schlechte Auflösung und ist überdies durch die Zahl der Verfahrensschritte sehr aufwendig.

Aus der US-A-4 349 620 ist ein Trockenfilmresist mit einer mehrlagigen, lichtempfindlichen Resistschicht bekannt. Die Resistschicht kann dabei negativarbeitend oder auch positivarbeitend sein. Die einzelnen, lichtempfindlichen Lagen der Resistschicht sollen gemäß der Lehre der US-A-4 349 620 derart unterschiedliche Eigenschaften besitzen, daß eine bessere Differenzierung der Hafteigenschaften der Resistschicht gegenüber dem temporären Schichtträger des Trockenfilmresistes, der temporären Deckschicht des Trockenfilmresistes bzw. dem endgültigen Substrat, auf das die Resistschicht auflaminiert wird, erzielt wird. Dadurch soll es möglich werden, die temporäre Deckfolie bzw. den temporären Schichtträger des Trockenfilmresistes problemloser als bei den bisher bekannten Materialien dieser Art bei seiner Verarbeitung von der lichtempfindlichen Resistschicht abzuziehen. Die differenzierten Hafteigenschaften der einzelnen Lagen der Resistschicht werden dabei insbesondere über eine Variation des Molekulargewichts des in der lichtempfindlichen Resistschicht enthaltenen polymeren Bindemittels bzw. des lichtempfindlichen polymeren Materials eingestellt. Im übrigen wird die Zusammensetzung der einzelnen Lagen der Resistschicht weitgehend gleichgehalten, insbesondere sollen die einzelnen Lagen vergleichbare Belichtungseigenschaften aufweisen. Bei diesem mehrlagigen Resistmaterial sind die gleichen langen Belichtungszeiten notwendig wie für eine entsprechende einlagige Resistschicht aus den gleichen Materialien.

Der Erfindung liegt die Aufgabe zugrunde, ein positiv arbeitendes, durch Belichtung mit aktinischem Licht löslich machbares Resistmaterial mit besseren Belichtungseigenschaften zur Verfügung zu stellen, welches für die Herstellung von bildmäßig strukturierten Resistschichten nach den an sich bekannten Verfahren geeignet ist. Das Resistmaterial soll insbesondere die Einhaltung kurzer Belichtungszeiten ermöglichen und gleichzeitig ein hohes Auflösungsvermögen besitzen, ohne daß andere wichtige Eigenschaften, wie Stabilität, mechanische und chemische Beständigkeit etc., des Resists beeinträchtigt werden. Es soll einfach handhabbar und verarbeitbar sein, eine exakte und orignalgetreue Bildwiedergabe auch in feinen Elementen ermöglichen und breit anwendbar sein.

Es wurde nun gefunden, daß diese Aufgabe gelöst wird, wenn man in dem Verfahren zur Herstellung einer bildmäßig strukturierten Resistschicht durch Aufbringen einer positiv arbeitenden, durch Bestrahlung mit aktinischem Licht löslich machbaren Resistschicht auf ein Substrat, bildmäßiges Belichten dieser Resistschicht und Auswaschen der belichteten Schichtanteile eine solches mehrlagiges Resistmaterial, vorteilhaft als Trockenfilmresist, einsetzt, dessen lichtempfindliche Resistschicht aus mindestens zwei, unmittelbar übereinander angeordneten Lagen mit unterschiedlicher Grundlöslichkeit gebildet wird, wobei mindestens die - bezogen auf das Substrat - obere Lage lichtempfindlich ist und durch Bestrahlen mit dem aktinischen Licht in dem Entwicklerlösungsmittel löslich oder dipergierbar wird, die - bezogen auf das Substrat - untere Lage eine höher Grundlöslichkeit in dem Entwicklerlösungsmittel besitzt und nach der bildmäßigen Belichtung die belichteten Bereiche der gesamten Resistschicht in einem Entwicklerlösungsmittel auswaschbar sind.

Gegenstand der Erfindung ist demzufolge ein Verfahren zur Herstellung von bildmäßig strukturierten Resistschichten, wie z.B. Resistmustern oder Lötstoppmasken, auf einem Substrat durch Aufbringen einer positiv arbeitenden, durch Bestrahlung mit aktinischem Licht löslich machbaren Resistschicht (R) auf das Substrat, bildmäßiges Belichten der lichtempfindlichen Resitschicht (R) mit aktinischem Licht und Entfernen der belichteten Schichtteile durch Auswaschen mit einem Entwicklerlösungsmittel, wobei die positiv arbeitende, lichtempfindliche Resistschicht (R) mindestens aus zwei, festen, unmittelbar übereinander angeordneten Lagen (L) gebildet wird, welches dadurch gekennzeichnet ist, daß zumindest die - nach dem Aufbringen auf das Substrat - oberste Lage (OL) der Resistschicht aus einem lichtempfindlichen Material besteht, das durch Bestrahlung mit aktinischem Licht in einem Lösungsmittel löslich oder dispergierbar wird, in dem es zuvor unlöslich war, und die - nach dem Aufbringen auf das Substrat - untere Lage (UL) der Resistschicht (R) in dem für das Auswaschen der bildmäßig belichteten Bereiche der Resistschicht (R) verwendeten Entwicklerlösungsmittel eine höhere Grundlöslichkeit aufweist als die obere Lage (OL).

Gegenstand der Erfindung ist weiterhin ein Trockenfilmresist, insbesondere zur Anwendung bei der Herstellung von gedruckten Schaltungen, elektronischen Bauelementen oder Lötstoppmasken, mit einem dimensionsstabilen temporären Schichtträger (T), einer darauf aufgebrachten, festen, laminierbaren, positiv arbeitenden durch Bestrahlung mit aktinischem Licht löslich machbaren Resistschicht (R) aus mindestens zwei verschiedenen Lagen (L) sowie vorzugsweise mit einer Deckschicht (D) auf der lichtempfindlichen Resistschicht (R), die von der lichtempfindlichen Resistschicht (R) ohne gleichzeitiges Entfernen des temporären Schichtträgers (T) abziehbar ist. Der Trockenfilmresist ist dadurch gekennzeichnet, daß die Lagen (L) der lichtempfindlichen Resistschicht (R) eine unterschiedliche Grundlöslichkeit besitzen, wobei zumindest die dem temporären Schichtträger (T) benachbarte Lage (OL) der Resistschicht (R) aus einem lichtempfindlichen Material besteht, das durch Bestrahlung mit aktinischem Licht in einem Lösungsmitttel löslich oder dispergierbar wird, in dem es zuvor unlöslich war, und die nicht mit dem temporären Schichtträger (T) verbundene Lage oder verbundenen Lagen (UL) der lichtempfindlichen Resistschicht (R) in dem für das Auswaschen der bildmäßig belichteten Bereiche der Resistschicht (R) zu verwendenden Entwicklerlösungsmittel eine höhere Grundlöslichkeit aufweist bzw. aufweisen als die obere Lage (OL).

Unter Grundlöslichkeit wird dabei im Rahmen dieser Erfindung die Neigung der einzelnen Lagen (L) der lichtempfindlichen Resistschicht (R), insbesondere der die Lagen (L) im allgemeinen bildenden oder zumindest im wesentlichen bildenden Polymeren verstanden, sich vor der Belichtung mit aktinischem Licht in dem für das Auswaschen der Resistschicht (R) verwendeten Entwicklerlösungsmittel zu lösen bzw. darin dispergiert werden zu können. Wenn die untere Lage (UL) eine höhere Grundlöslichkeit besitzen soll als die obere Lage (OL) der lichtempfindlichen Resistschicht (R), beinhaltet dies dementsprechend sowohl die Möglichkeit, daß die untere Lage (UL) - im Gegensatz zu der oberen Lage (OL) - bereits vor der bildmäßigen Belichtung mit dem aktinischen Licht in dem für die Entwicklung notwendigen Maße in dem Entwicklerlösungsmittel löslich oder dispergierbar ist, als auch die Möglichkeit, daß die untere Lage (UL) ebenfalls vor der Belichtung mit aktinischem Licht in dem für die Entwicklung der Resistschicht (R) verwendeten Entwicklerlösungsmittel unlöslich bzw. nicht dispergierbar ist, diesem gegenüber jedoch eine größere Solveophilie aufweist als die obere Lage (OL). Dadurch wird bewirkt, daß die untere Lage (UL) im Vergleich zu der oberen Lage (OL) der lichtempfindlichen Resistschicht (R) bei gleicher Bestrahlungsintensität in kürzerer Zeit oder bei gleicher Bestrahlungsdauer mit einer geringeren Bestrahlungsintensität in dem Entwicklerlösungsmittel löslich oder dispergierbar gemacht werden kann.

Die Differenzierung der Grundlöslichkeit der einzelnen Lagen (L) der lichtempfindlichen Resistschicht (R) wird über ihre Zusammensetzung erzielt, d.h. über Art und Menge der diese Lagen (L) bildenden Komponenten, insbesondere über die Art bzw. die Zusammensetzung des oder der in den Lagen (L) im allgemeinen als wesentlicher Bestandteil enthaltenen Polymeren. Die höhere Grundlöslichkeit der unteren Lage (UL) wird am einfachsten dadurch erreicht, daß diese Lage als wesentlichen Bestandteil ein Polymeres enthält bzw. aus einem Polymeren gebildet wird, welches - im Vergleich zu den in der oberen Lage (OL) enthaltenen Polymeren - eine größere Anzahl an solveophilen Gruppen eingebaut enthält. Da die bekannten, positiv arbeitenden, durch Belichtung löslich machbaren Resistschichten im allgemeinen Polymere enthalten, die nach der Belichtung mit wäßrig-alkalischen Entwicklerlösungsmitteln auswaschbar sind, kann die höhere Grundlöslichkeit der unteren Lage (UL) insbesondere durch einen höheren Anteil an Säuregruppen, vorzugsweise Carbonsäuregruppen, Säureanhydridgruppen oder auch anderen, die Hydrophilie erhöhenden Gruppen in dem Polymeren der unteren Lagen (UL) erzielt werden. Vorzugsweise liegen die mittleren Molekulargewichte der Polymeren in der oberen Lage (OL) und in der unteren Lage (UL) in der gleichen Größenordnung; vorzugsweise ist das mittlere Molekulargewicht des Polymeren, welches den wesentlichen Bestandteil der unteren Lage (UL) bildet, gleich oder zumindest ähnlich oder auch größer als das mittlere Molekulargewicht des Polymeren, welches den wesentlichen Bestandteil der oberen Lage (OL) der lichtempfindlichen Resistschicht (R) bildet.

Bei den erfindungsgemäß, mehrlagigen, positiv arbeitenden, lichtempfindlichen Resistschichten tritt schon bei kurzer Belichtungszeit eine Löslichkeit der Resistschicht (R) bis in den unteresten, auf der Substratoberfläche aufgebrachten Schichtbereich ein, so daß die Resistschicht (R) einwandfrei über die gesamte Schichtdicke mit einem Entwicklerlösungsmittel ausgewaschen werden kann. Besonders überraschend ist dabei die Tatsache, daß durch die Verkürzung der Belichtungszeit keine Einbußen bei anderen wichtigen Eigenschaften der Resistmaterialien, wie z.B. Überwaschempfindlichkeit, Auflösung, mechanische oder chemische Beständigkeit, beispielsweise gegenüber den Prozeßchemikalien bei der Herstellung und Weiterverarbeitung der bildmäßig strukturierten Resistschichten, in Kauf genommen werden müssen.

Die nach dem Aufbringen der erfindungsgemäßen, mehrlagigen Resistschicht (R) auf das temporär oder permanent zu schützende Substrat obere Lage (OL) ist fest, stets lichtempfindlich und hat bei Einsatz der lichtempfindlichen Resistschicht (R) in Form eines Trockenfilmresists eine mäßige Haftung gegenüber dem temporären Schichtträger (T), der nach dem Aufbringen der lichtempfindlichen Resistschicht (R) auf das Substrat von der oberen Lage (OL) vor oder nach der bildmäßigen Belichtung der Resistschicht (R) abgezogen werden können soll. Für die obere Lage (OL) kommen grundsätzlich alle bekannten, positiv arbeitenden Aufzeichnungsmaterialien in Betracht, die bei Belichtung mit aktinischem Licht in einem Lösungsmittel löslich werden, in dem sie zuvor unlöslich waren. Hierzu

gehören beispielsweise die positiv arbeitenden Aufzeichnungsmaterialien auf Basis von o-Chinondiazid-Gruppen enthaltenden Polymeren, wie sie in der eingangs zitierten Patentliteratur beschrieben sind. Die Resistmaterialien auf Basis von o-Chinondiazid-Verbindungen werden im allgemeinen durch Veresterung eines o-Chinondiazides in Gegenwart von Hydroxylgruppen enthaltenden Polymeren hergestellt. Die o-Chinondiazide haben dabei Carbonsäure- bzw. Sulfonsäure-Gruppen, die mit der polymeren Hydroxyl-Komponente eine Veresterungsreaktion eingehen können. Als polymere Hydroxyl-Komponente kommen beispielsweise polymere Polyole wie z.B. Polyvinylalkohol, hydroxy-substituierte Homo- oder Copolymerisate von (Meth)Acrylsäureestern, natürliche Kolloide wie Gelatine etc. in Betracht. Im übrigen wird bezüglich der Herstellung und des Aufbaus der für positiv arbeitende Resistmaterialien in Betracht kommenden o-Chinondiazid-Gruppen enthaltenden Polymeren sowie bezüglich der Zusammensetzung solcher Resistmaterialien auf Basis von o-Chinondiaziden auf die einschlägige, dem Fachmann bekannte Literatur verwiesen.

Mit besonderem Vorteil wird die obere Lage (OL) der erfindungsgemäßen lichtempfindlichen Resistschichten (R) aus einem positiv-arbeitenden lichtempfindlichen Resistmaterial gebildet, welches als lichtempfindliche Komponente eine Verbindung mit mindestens zwei aromatischen und/oder heteroaromatischen o-Nitrocarbinolester-Gruppierungen der allgemeinen Formel (I)

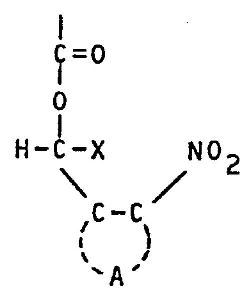

(I)

enthält, worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 Kohlenstoffatomen oder einen gegebenenfalls substituierten Aryl- oder Aralkylrest bedeuten. Insbesondere geeignet sind solche Resistmaterialien, die als lichtempfindliche Komponente ein Polymeres mit einem Molekulargewicht größer 500 enthalten, das mindestens 5 Gew.%, bezogen auf das Molekulargewicht des Polymeren, an aromatischen und/oder heteroaromatischen o-Nitrocarbinolester--Gruppierungen der allgemeinen Formel (I) eingebaut enthält. Derartige, sehr vorteilhafte Resistmaterialien und ihre Verarbeitung zu bildmäßig strukturierten Resistschichten sind beispielsweise in der DE-C-21 50 691,

der DE-A-29 22 746 sowie der DE-A-32 31 147 und DE-A-33 26 036 beschrieben. In den Verbindungen mit den aromatischen und/oder heteroaromatischen o-Nitrocarbinolester-Grupperiungen der allgemeinen Formel (I) kann das aromatische oder heteroaromatische Ringsystem A mit der o-ständigen Nitrogruppe ein- oder mehrkernig sein. Unter den aromatischen Ringsystemen ist insbesondere das Benzol bevorzugt, wobei der Benzolring ein- oder mehrfach substituiert sein kann, beispielsweise durch $C_1$-$C_8$-Alkyl, insbesondere Methyl, durch $C_1$-$C_6$-Alkoxy, insbesondere Methoxy, durch Halogen, wie Chlor oder Brom, durch Nitro-, Amino-, Monomethylamino-, Dimethylamino-, Nitril- oder Sulfo-Gruppen. Als mehrkernige aromatische Ringsysteme kommen z.B. Naphthalin, Anthracen, Anthrachinon, Phenanthren oder die entsprechenden substituierten Derivate in Betracht. Als heteroaromatisches Ringsystem ist der Pyridinrest bevorzugt. In der allgemeinen Formel (I) ist X insbesondere ein Wasserstoffatom, der Methyl- oder Ethylrest oder der gegebenenfalls substituierte Phenylrest. Beispiele für besonders bevorzugte aromatische oder heteroaromatische o-Nitrocarbinole, die den o-Nitrocarbinolestergruppierungen der allgemeinen Formel (I) zugrundeliegen, sind o-Nitrobenzylalkohol, 2-Nitro-6-chlor-benzylalkohol, 2-Nitro-4-cyanobenzylalkohol, 2-Nitro-4,5-dimethoxybenzylalkohol, α-Methyl-o-nitrobenzylalkohol, α-Phenyl-o-nitrobenzylalkohol, α-(o-Nitrophenyl)-o-nitrobenzylalkohol und 2-Nitro-3-hydroxymethylpyridin.

Bei den Verbindungen mit den aromatischen und/oder heteroaromatischen o-Nitrocarbinolestergruppierungen kann es sich um niedermolekulare Ester mit zwei oder mehr Estergruppierungen der allgemeinen Formel (I) handeln, wie insbesondere die Di- und/oder Polyester von niedermolekularen Di- und/oder Polycarbonsäuren mit aromatischen und/oder heteroaromatischen o-Nitrocarbinolen der in Rede stehenden Art. In diesem Fall enthält das lichtempfindliche Material für die obere Lage (OL) der erfindungsgemäßen Resistschichten (R) noch ein mit diesen Estern verträgliches polymeres Bindemittel, wobei sich hierfür z.B. Acrylat- und/oder Methacrylat-Polymerisate besonders bewährt haben. Als polymere Bindemittel kommen in diesem Fall aber auch hochmolekulare Verbindungen mit funktionellen Gruppen in Betracht, die gegenüber Carboxylgruppen vernetzend wirken, wie insbesondere Polyepoxide.

Besonders bewährt haben sich für die obere Lage (OL) solche lichtempfindlichen Resistmaterialien, die als lichtempfindliche Komponente ein Polymeres mit einem Molekulargewicht größer 500 enthalten, welches mindestens 5 Gew.%, bezogen auf das Molekulargewicht des Polymeren, an aromatischen und/oder heteroaromatischen o-Nitrocarbinolestergruppierungen der allgemeinen Formel (I) im Molekül gebunden enthält. Vorzugsweise liegt das mittlere Molekulargewicht (Zahlenmittel) dieser Polymeren im Bereich von 10.000 bis 100.000. Als das die o-Nitrocarbinolestergruppierungen tragende Polymer kommt zweckmäßigerweise eine organische Polycarbonsäure in Betracht, deren Carboxylgruppen mit den aromatischen und/oder heteroaromatischen o-Nitrocarbinolen verestert sind. Bei den organischen Polycarbonsäuren handelt es sich im allgemeinen um Homo- oder Copolymere von ethylenisch ungesättigten Mono- oder Dicarbonsäuren mit 3 bis 6 C-Atomen, insbesondere um Homo- oder Copolymerisate von α,ß-ungesättigten Mono- oder Dicarbonsäuren, wie Acrylsäure, Methacrylsäure, Maleinsäure, Fumarsäure und/oder Crotonsäure. Die Carboxylgruppen dieser Polycarbonsäuren können dabei ganz oder teilweise mit den aromatischen und/oder heteroaromatischen o-Nitrocarbinolen verestert sein. Die lichtempfindlichen, o-Nitrocarbinolestergruppierungen tragenden Polymeren können dabei neben den ganz oder teilweise mit den o-Nitrocarbinolen veresterten ungesättigten Carbonsäuren ein oder mehrere Comonomere eingebaut enthalten. Als Comonomeren kommt dabei Ethylen, Styrol und den $C_1$-$C_8$-Alkylestern der oben genannten ethylenisch ungesättigten Carbonsäuren, insbesondere den Alkyl(meth)acrylaten, besondere Bedeutung zu. Als Beispiel für geeignete lichtempfindliche Polymere seien dabei z.B. die (Meth)acrylsäure/(Meth)acrylat-Copolymerisate genannt, deren Carbonsäuregruppen ganz oder teilweise mit den in Rede stehenden aromatischen und/oder heteroaromatischen o-Nitrocarbinolen verestert sind. Die lichtempfindlichen Polymere können neben den o-Nitrocarbinolestergruppierungen der allgemeinen Formel (I) auch noch weitere reaktive, funktionelle Gruppen eingebaut enthalten, wie beispielsweise Hydroxyl-, Amin-, Amid-, N-Methylolamid-, Epoxid- und/oder verkappte Isocyanat-Gruppen. Als Beispiele für Comonomere, die solche reaktiven, funktionellen Gruppen enthalten und die in den lichtempfindlichen, o-Nitrocarbinolestergruppierungen der allgemeinen Formel (I) enthaltenden Polymeren enthalten sein können, seien genannt: N,N-Dimethylaminoethyl-(meth)acrylat, N-Vinylimidazol, (Meth)acrylamid, Hydroxyalkyl-(meth)acrylate, Methylolverbindungen vom Amoltyp, z.B. N-Methylol(meth)acrylamid, Glycidyl-(meth)acrylat, Allylglycidylether, 4-Vinylcyclohexendioxid und ähnliche. Die lichtempfindlichen, o-Nitrocarbinolestergruppierungen enthaltenen Polymeren können nach an sich üblichen und bekannten Verfahren beispielsweise durch Polymerisation von aromatischen und/oder heteroaromatischen o-Nitrocarbinolestern ethylenisch ungesättigter Carbonsäuren der in Rede stehenden Art, insbesondere der Acryl- und/oder Methacrylsäure, alleine oder vorteilhaft mit Comonomeren der genannten Art, insbesondere (Meth)acrylsäure-Derivaten hergestellt werden.

Die Menge an aromatischen und/oder heteroaromatischen o-Nitrocarbinolestergruppierungen in diesen Polymeren wird im allgemeinen nicht unter 5 Gew.%, bezogen auf das Molekulargewicht des Polymeren liegen und kann in Abhängigkeit, insbesondere der gewünschten Eigenschaften der Resistmaterialien in weiten Grenzen schwanken. Da bei der Belichtung mit aktinischem Licht die o-Nitrocarbinolestergruppierungen gespalten und freie Carboxylgruppen im Polymeren gebildet werden, wodurch die Löslichkeit des Polymeren geändert wird, sind die o-Nitrocarbinolestergruppierungen in dem Polymeren maßgebend für die Löslichkeitsänderung der lichtempfindlichen Resistmaterialien auf Basis dieser Polymeren bei ihrer bildmäßigen Belichtung mit aktinischem Licht. Der Gehalt an o-Nitrocarbinolestergruppierungen der allgemeinen Formel (I) in den Polymeren ist daher im allgemeinen so zu wählen, daß die damit hergestellten Resistschichten oder Lagen nach der Belichtung mit aktinischem Licht in wäßrigen Entwicklerlösungsmitteln, insbesondere wäßrig-alkalischen Lösungen, löslich oder zumindest dispergierbar werden. Vorzugsweise liegt der Gehalt an aromatischen und/oder heteroaromatischen o-Nitrocarbinolestergruppierungen der allgemeinen Formel (I) in den lichtempfindlichen Polymeren im Bereich von 10 bis 30 Gew.%, bezogen auf das Molekulargewicht des Polymeren. Die lichtempfindlichen, o-Nitrocarbinolestergruppierungen der allgemeinen Formel (I) enthaltenden Polymeren können allein oder auch in Mischung miteinander eingesetzt werden.

Die für die obere Lage (OL) der erfindungsgemäßen Resistschichten (R) einzusetzenden lichtempfindlichen Resistmaterialien können neben den genannten lichtempfindlichen Verbindungen, die durch Bestrahlung mit aktinischem Licht in einem Lösungsmittel löslich werden, in dem sie vorher nicht löslich waren, insbesondere den o-Nitrocarbinolestergruppierungen der allgemeinen Formel (I) enthaltenden Verbindungen und insbesondere den Polymeren mit den aromatischen und/oder heteroaromatischen o-Nitrocarbinolestergruppierungen, weitere, die allgemeinen Eigenschaften dieser Resistmaterialien verbessernde und/oder modifizierende Zusatz- und/oder Hilfsstoffe enthalten. Hierzu gehören beispielsweise Sensibilisatoren, die die Lichtempfindlichkeit und die spektrale Empfindlichkeit der Resistmaterialien verbessern, Farbstoffe, Pigmente und/oder photochrome Substanzen, Weichmacher, Verlaufshilfsmittel, feinteilige Füllstoffe etc. Beispiele für Sensibilisatoren sind Xanthen-Farbstoffe, wie Fluorescein, Eosin und Rhodamin S, sowie Triplett-Energie-Überträger, wie sie beispielsweise N.J. Turro in seinem Buch "Molecular Photochemistry", WA. Benjamin Inc., New York, 1967, auf Seite 132 beschreibt. Als Farbstoffe haben sich unter anderem Sudanfarbstoffe, Polymethin-Farbstoffe, Azofarbstoffe, Phthalocyanin-Farbstoffe oder Dispersionsfarbstoffe sowie Eosin, Kristallviolett oder Malachitgrün bewährt. Besonders vorteilhaft sind

solche Farbstoffe, die bei der Belichtung mit aktinischem Licht ihre Färbung reversibel oder irreversibel ändern. Als Beispiele für Weichmacher, die vorzugsweise mit den anderen Komponenten der Resistmaterialien, insbesondere den darin enthaltenen Polymeren, verträglich sein sollen, seien Trikresylphosphat, n-Butyl-benzyl-phthalat und flüssige Polyester aus aliphatischen Dicarbonsäuren und bifunktionellen Glykolen, insbesondere Polyester aus Adipinsäure und 1,2-Propylenglykol oder 1,4-Butandiol mit einer Viskosität von 1.000 bis 15.000 cP genannt. Zu den Verlaufshilfsmitteln, die insbesondere bei der Verarbeitung der Resistmaterialien aus Lösung eingesetzt werden, zählen beispielsweise Silikonöle. Als Füllstoffe, deren Zusatz sich insbesondere bei der Herstellung von Lötstoppmasken als vorteilhaft erwiesen hat, kommen z.B. Talkum, Calciumcarbonat, Siliciumdioxide wie etwa Quarzmehl, amorphe Kieselsäure, pyrogene Kieselsäure, Silikate wie z.B. Aluminiumsilikate, Silikatgläser, Aluminiumoxide, Glaspulver oder Glasstaub, Bentonite etc. in Frage. Die mittlere Teilchengröße dieser Füllstoffe liegt im allgemeinen im Bereich von 5 bis 100 nm, vorzugsweise im Bereich von 10 bis 50 nm.

In den lichtempfindlichen Resistmaterialien auf Basis von o-Nitrocarbinolestergruppierungen der allgemeinen Formel (I) enthaltenen Verbindungen, insbesondere der aromatische und/oder heteroaromatische o-Nitrocarbinolestergruppierungen enthaltenden Polymeren, können in einer besonderen Ausgestaltungsform als Zusatzstoffe auch niedermolekulare und/oder hochmolekulare Verbindungen mit zwei oder mehr reaktiven, funktionellen Gruppen enthalten sein, die unter dem Einfluß von Wärme mit den freien Carboxylgruppen, die bei der Belichtung der die o-Nitrocarbinolestergruppierungen der allgemeinen Formel (I) enthaltenden Verbindungen freigesetzt werden, oder mit den anderen funktionellen, reaktiven Gruppen, die in den lichtempfindlichen Polymeren neben den aromatischen und/oder heteroaromatischen o-Nitrocarbinolestergruppierungen enthalten sein können, zu reagieren vermögen. Günstig sind dabei als Zusatzstoffe solche vernetzend wirkenden Verbindungen mit funktionellen, reaktiven Gruppen, bei denen die thermische Vernetzungsreaktion mit den o-Nitrocarbinolestergruppierungen der allgemeinen Formel (I) enthaltenden Verbindungen bei Temperaturen oberhalb 50°C, insbesondere bei Temperaturen oberhalb 80°C, abläuft. Als Beispiele für derartige Zusatzstoffe seien solche niedermolekularen und/ oder hochmolekularen Verbindungen genannt, die zwei oder mehr Hydroxy-, Amin-, N-Methylolamid-, Amid-, Epoxid- und/oder, vorzugsweise verkappte, Isocyanat-Gruppen im Molekül enthalten.

Als Beispiele für solche vernetzend wirkenden Zusatzstoffe mit funktionellen, reaktiven Gruppen, seien genannt: die Di- oder Polyepoxide,

welche die Umsetzungsprodukte von Epichlorhydrin mit Polyolen, die Umsetzungsprodukte von Epichlorhydrin mit Polyaminen, Polyolefinepoxide, epoxidiertes Polybutadien, Epoxidharze vom Novolak-Typ, Hochpolymere vom Glycidylestern ungesättigter Carbonsäuren, insbesondere der (Meth)acrylsäure und andere umfassen; Di- oder Polyisocyanate, insbesondere verkappte Di- oder Polyisocyanate, wobei als schützende Komponente für die Verkappung insbesondere Phenole, Acetonoxim, Methylethylketoxim, Acetessigester oder Malonester in Frage kommen; Hydroxy-, Amino- und/oder N-Methylol-Gruppen enthaltende Polymere, wie beispielsweise Phenol-Formaldehyd-Harze, Harnstoff-Formaldehyd-Harze und Melamin-Formaldehyd-Harze, wobei die Harze vom Novolak-Typ bevorzugt sind. Die niedermolekularen, vernetzend wirkenden Zusatzstoffe der genannten Art können auch als Weichmacher fungieren, so daß bei ihrer Mitverwendung der Zusatz von anderen Weichmachern ganz oder teilweise entfallen kann.

In den lichtempfindlichen Resistmaterialien, die als Zusatzstoffe vernetzend wirkende Verbindungen mit funktionellen reaktiven Gruppen enthalten oder die lichtempfindliche Polymere mit weiteren, funktionellen, reaktiven Gruppen enthalten, können auch photochemisch und/oder thermisch aktivierbare Katalysatoren für solche Nachvernetzungs- und Nachhärtungsreaktionen als Zusatzstoffe enthalten sein. Hierbei kann es sich z.B. um Diazoniumsalze, die Oniumsalze der Elemente der V., VI. und VII. Hauptgruppe des Periodensystems, Sulfoxoniumsalze, Pyrriliumsalze etc. handeln.

Die Zusatz- und/oder Hilfsstoffe werden in den lichtempfindlichen Resistmaterialien in üblichen und an sich bekannten Mengen eingesetzt. Da die oben erwähnten, vernetzend wirkenden Zusatzstoffe mit funktionellen, reaktiven Gruppen insbesondere der Erhöhung der mechanischen und/oder chemischen Stabilität der Resistschichten nach der bildmäßigen Belichtung dienen, wird ihr Anteil in den Resistmaterialien im allgemeinen entsprechend dem gewünschten Vernetzungs- und Härtungsgrad der bildmäßig strukturierten Resistschichten gewählt.

Die lichtempfindlichen Resistmaterialien für die obere Lage (OL) der erfindungsgemäßen Resistschichten (R) können durch homogenes Vermischen der einzelnen Komponenten beispielsweise in geeigneten Lösungsmittel, wie z.B. Aceton, Essigsäureethylester, Toluol oder Methylenchlorid, und Gießen dieser Lösungen zu einer Lage der gewünschten Schichtstärke hergestellt werden.

Die nach dem Aufbringen auf das zu modifizierende oder permanent zu schützende Substrat untere Lage (UL) der erfindungsgemäßen lichtempfindlichen Resistschicht (R) ist ebenfalls fest und wird in ihrer Zusammensetzung so gewählt, daß sie eine gute Haftung gegenüber dem Substrat und gegenüber der mit ihr verbundenen oberen Lage (OL) der Resistschicht (R) besitzt. Wird die erfindungsgemäße lichtempfindliche Resistschicht (R) als Trockenfilmresist eingesetzt, so soll die untere Lage (UL) nur eine geringe Haftung gegenüber der Deckschicht (D) des Trockenfilmresistes aufweisen, die insbesondere geringer ist als die Haftung zwischen der oberen Lage (OL) der Resistschicht (R) und dem temporären Schichtträger (T) des Trockenfilmresistes. Dadurch wird ein problemloses Abziehen der Deckschicht (D) von der unteren Lage (UL) vor dem Aufbringen der lichtempfindlichen Resistschicht (R) auf das Substrat ermöglicht. Bei Einsatz als Trockenfilmresist ist die untere Lage (UL) der erfindungsgemäßen lichtempfindlichen Resistschicht (R) darüber hinaus in ihrer Zusammensetzung so zu gestalten, daß sie nach den für Trockenfilmresiste bekannten und üblichen Verfahren unter Anwendung von Druck sowie gegebenenfalls Wärme auf das Substrat unter Ausbildung einer hinreichenden und guten Haftung aufgebracht, insbesondere auflaminiert, werden kann.

Je nach Anwendung der erfindungsgemäßen lichtempfindlichen Resistschichten (R) kann die Grundlöslichkeit der unteren Lage (UL) bereits schon so hoch sein, daß sie ohne Bestrahlung mit aktinischem Licht mit dem Entwicklerlösungsmittel ausgewaschen werden kann. In diesem Fall braucht die untere Lage (UL) nicht lichtempfindlich zu sein, kann es aber; für die bildmäßige Strukturierung der Resistschicht reicht es hin, wenn die obere Lage (OL) lichtempfindlich ist. Dies gilt insbesondere für die Anwendungsfälle, in denen die Auflösung bei der bildmäßigen Strukturierung der Resistschicht (R) keine entscheidende Rolle spielt, wie z.B. bei der Herstellung von permanenten Schutz- und Isolierschichten, insbesondere Lötstoppmasken. Für andere Anwendungszwecke, insbesondere bei der Herstellung von Ätz- oder Galvano-Resisten, gedruckten Schaltungen, Dünnschichtschaltungen etc. ist es sinnvoll, wenn die untere Lage (UL) der erfindungsgemäßen lichtempfindlichen Resistschicht (R) nicht von vornherein in dem zu verwendenden Entwicklerlösungsmittel löslich ist, sondern ebenso wie die obere Lage (OL) erst durch Bestrahlen mit aktinischem Licht hierin auswaschbar wird. In diesem Fall wird auch die untere Lage (UL) aus einem positiv arbeitenden, lichtempfindlichen Resistmaterial gebildet, welches bei Bestrahlung mit aktinischem Licht in einem Lösungsmittel löslich wird, indem es zuvor unlöslich war.

In dem Fall, indem auch die unter Lage (UL) der erfindungsgemäßen Resistschichten (R) aus einem lichtempfindlichen Resistmaterial gebildet wird, kann dieses grundsätzlich ein beliebiges, positiv arbeitendes Resistmaterial sein, wie es vorstehend für die obere Lage (OL) beschrieben worden

ist, sofern es eine höhere Grundlöslichkeit als das Resistmaterial der oberen Lage (OL) aufweist. Vorzugsweise wird die untere Lage (UL) aus einem solchen lichtempfindlichen Resistmaterial gebildet, welches mit Ausnahme der Grundlöslichkeit dem der oberen Lage (OL) weitgehend ähnlich ist. Vorzugsweise besteht auch in diesem Fall die untere Lage (UL) aus einem lichtempfindlichen Resistmaterial auf Basis von o-Nitrocarbinolestergruppierungen der allgemeinen Formel (I) enthaltenden Verbindungen, insbesondere auf Basis von Polymeren mit einem Molekulargewicht größer 500, die mindestens 5 Gew.% an aromatischen und/oder heteroaromatischen o-Nitrocarbinolestergruppierungen der allgemeinen Formel (I) eingebaut enthalten. Bezüglich der o-Nitrocarbinolestergruppierung enthaltenden Verbindungen, insbesondere der o-Nitrocarbinolestergruppierungen enthaltenden Polymeren, und der Zusatz- und/oder Hilfsstoffe für diese lichtempfindlichen Resistmaterialien gilt das weiter oben gesagte entsprechend.

Da die in Rede stehenden, positiv arbeitenden lichtempfindlichen Resistmaterialien im allgemeinen bei Belichtung mit aktinischem Licht freie Säuregruppen, insbesondere freie Carboxylgruppen, bilden, kann bei ihrer Verwendung für die Herstellung der unteren Lage (UL) der erfindungsgemäßen lichtempfindlichen Resistschichten (R) die höhere Grundlöslichkeit im Vergleich zur oberen Lage (OL) im allgemeinen in einfacher Weise dadurch eingestellt werden, daß die lichtempfindlichen Resistmaterialien für die untere Lage (UL) einen höheren Anteil an hydrophilen Gruppen, insbesondere Säuregruppen oder Säureanhydrid-Gruppen, und speziell freien Carbonsäure-Gruppen, enthalten. Bei den bevorzugten lichtempfindlichen Resistmaterialien auf Basis von o-Nitrocarbinolestergruppierungen der allgemeinen Formel (I) enthaltenden Verbindungen kann dies am einfachsten durch Verwendung von hydrophile Gruppen, insbesondere Säuregruppen wie Carbonsäuregruppen, enthaltenden Polymeren in den lichtempfindlichen Resistmaterialien geschehen. Bei den Resistmaterialien auf Basis von niedermolekularen, lichtempfindlichen o-Nitrocarbinolestergruppierungen der allgemeinen Formel (I) enthaltenden Verbindungen sind diese hydrophilen Gruppen in dem mitverwendeten polymeren Bindemittel eingebaut. Bei den insbesondere bevorzugten Resistmaterialien auf Basis von o-Nitrocarbinolestergruppierungen der allgemeinen Formel (I) enthaltenden Polymeren werden dabei vorteilhafterweise solche lichtempfindlichen, o-Nitrocarbinolestergruppierungen der allgemeinen Formel (I) enthaltenden Copolymerisate verwendet, die einen erhöhten Anteil an ungesättigten Carbonsäuren, insbesondere (Meth)acrylsäure, einpolymerisiert enthalten.

In den lichtempfindlichen Resistmaterialien für die unter Lage (UL) der erfindungsgemäßen Resistschichten (R) wird der Anteil an hydrophilen Gruppen, insbesondere freien Säuregruppen, die vorzugsweise in den Polymeren der Resistmaterialien eingebaut sind, so gewählt, daß das lichtempfindliche Resistmaterial vor der Belichtung zwar noch nicht mit dem für die Entwicklung der belichteten Resistschichten (R) verwendeten Entwicklerlösungsmittel ausgewaschen werden kann, jedoch im Vergleich zum Resistmaterial der oberen Lage (OL) bei gleicher Belichtungsdauer, aber einer geringeren Strahlungsintensität auswaschbar wird. Insbesondere wird bei Verwendung von lichtempfindlichen Resistmaterialien für die untere Lage (UL) deren Grundlöslichkeit so eingestellt, daß - bei gleicher Belichtungsdauer - im Vergleich zur oberen Lage (OL) bereits etwa 5 bis 30 %, insbesondere etwa 10 %, der Strahlungsintensität ausreicht, um die untere Lage (UL) in dem Entwicklerlösungsmittel löslich zu machen.

In dem Fall, in dem die untere Lage (UL) der erfindungsgemäßen lichtempfindlichen Resistschichten (R) bereits von vornherein, d.h. ohne Belichtung mit aktinischem Licht, in dem Entwicklerlösungsmittel löslich bzw. dispergierbar ist, kann diese untere Lage (UL) aus beliebigen polymeren Materialien aufgebaut sein, die in dem Entwicklerlösungsmittel löslich oder dispergierbar sind und die Zusatz- und/oder Hilfsstoffe der oben genannten Art enthalten können. Hierzu gehören beispielsweise Polymere der Art, wie sie in der oberen Lage (OL) der lichtempfindlichen Resistschicht (R) enthalten sind, die jedoch eine entsprechend hohe Löslichkeit in dem Entwicklerlösungsmittel besitzen. Als Beispiel hierfür seien die o-Nitrocarbinolestergruppierungen der allgemeinen Formel (I) enthaltenden Polymeren mit einem hinreichend hohen Anteil an freien Carboxylgruppen genannt. Da als Entwicklerlösungsmittel insbesondere wäßrig-alkalische Medien in Betracht kommen, kann in diesen Fällen die untere Lage (UL) der erfindungsgemäßen lichtempfindlichen Resistschichten (R) aus solchen in wäßrig-alkalischen Medien löslichen oder dispergierbaren Polymeren gebildet werden, wie sie für negativ arbeitende, wäßrige entwickelbare Resistschichten bekannt und in der Literatur beschrieben sind. Hierzu gehören neben Styrol/Maleinsäureanhydrid-Copolymerisaten und Styrol/ Maleinsäurehalbester-Copolymerisaten insbesondere die Copolymerisate auf Basis von α,ß-olefinisch ungesättigten Monocarbonsäuren, vorzugsweise Acrylsäure und/oder Methacrylsäure. Als besonders vorteilhaft haben sich Copolymerisate erwiesen, die neben (Meth)acrylsäure als weitere Comonomere (Meth)-acrylate, insbesondere von Alkanolen mit 1 bis 20 C-Atomen, vorzugsweise mit 1 bis 8 C-Atomen, wie z.B. Methyl(meth)acrylat, Ethyl(meth)acrylat, Propyl(meth)acrylat, Butyl(meth)acrylat oder Hexyl(meth)acrylat, einpolymerisiert enthalten. Die (Meth)acrylsäure-Copolymerisate können neben den Alkyl-(meth)acrylaten oder an deren Stelle auch andere Comonomeren, insbesondere solche mit funktionellen, reaktiven Gruppen, beispielsweise Hydroxy-, Amin-, Amid-, N-Methylolamid-, Epoxid- oder ähnlichen Gruppen eingebaut enthalten. Beispiele für solche Comonomeren mit funktionellen

Seitengruppen sind Hydroxyalkyl(meth)acrylate, (Meth)acrylamid, N-Methylol-(meth)acrylamid und Glycidyl(meth)acrylat.

In dem Fall, in dem die untere Lage (UL) der erfindungsgemäßen lichtempfindlichen Resistschichten (R) von vornherein, d.h. ohne Belichtung mit aktinischem Licht, in dem Entwicklerlösungsmittel löslich oder dispergierbar ist, haben die Polymeren, aus denen die untere Lage (UL) im wesentlichen aufgebaut ist, vorzugsweise ein mittleres Molekulargewicht, welches dem Molekulargewicht der in der oberen Lage (OL) enthaltenen Polymeren vergleichbar oder auch höher ist als dieses. Insbesondere liegt das mittlere Molekulargewicht (Zahlenmittel) der eine solche untere Lage (UL) bildenden Polymeren im Bereich von 10.000 bis 100.000. Die in diesem Fall die untere Lage (UL) bildenden Polymeren können zur Verbesserung und/oder Modifizierung der allgemeinen Eigenschaften der unteren Lage (UL) ebenfalls Zusatz- und/oder Hilfsstoffe der weiter oben genannten Art enthalten. Hierzu gehören insbesondere Weichmacher, Verlaufshilfsmittel, Farbstoffe, Pigmente, Füllstoffe etc., aber auch vernetzend wirkende Verbindungen mit zwei oder mehr funktionellen, reaktiven Gruppen, die mit den Säuregruppen, insbesondere Carbonsäuregruppen und/oder den gegebenenfalls weiteren in den Polymeren enthaltenen funktionellen Gruppen bei erhöhten Temperaturen, insbesondere bei Temperaturen über 50°C, vorzugsweise bei Temperaturen über 80°C, eine thermische Vernetzungsreaktion eingehen können. Als solche vernetzend wirkenden Zusatzstoffe kommen insbesondere die weiter oben angesprochenen Di- oder Polyepoxide, verkappten Di- oder Polyisocyanate, Di- oder Polyhydroxide, Di- oder Polyamine, Di- oder Poly--N-methylolverbindungen und ähnliche in Betracht. Des weiteren können in der unteren Lage (UL) auch insbesondere thermisch aktivierbare Katalysatoren enthalten sein, die ein Ablaufen dieser thermischen Vernetzungsreaktion im Temperaturbereich insbesondere von 80 bis 150°C ermöglichen. Geeignete Katalysatoren sind dabei z.B. Dicyandiamid, Melamin-Formaldehyd--Harze und Komplexe von Aminen, die erst bei höheren Temperaturen spalten, wie z.B. der Komplex aus Bortrifluorid und Ethylamin; ferner thermisch aktivierbare, kationische Systeme, wie z.B. die bekannten Iodonium-, Phosphonium- oder Sulfoniumsalze.

Die erfindungsgemäßen lichtempfindlichen Resistschichten (R) können nach den für mehrlagige Resistmaterialien an sich bekannten und üblichen Verfahrenstechniken hergestellt werden. Beispielsweise ist es möglich, zunächst die obere Lage (OL) und die untere Lage (UL) getrennt herzustellen, indem man beispielsweise Lösungen aus den diese Lagen bildenden Bestandteilen zu Schichten der gewünschten Schichtstärke gießt, das Lösungsmittel abdampft, die einzelnen Lagen trocknet und anschließend unter Anwendung von Druck und gegebenenfalls Wärme miteinander verbindet.

Gleichermaßen ist es auch möglich, zunächst nur die obere oder untere Lage der erfindungsgemäßen Resistschichten, beispielsweise durch Gießen aus Lösung, herzustellen und anschließend darauf die andere Lage ebenfalls durch Gießen aus Lösung aufzubringen. Die Gesamtdicke der erfindungsgemäßen, mehrlagigen lichtempfindlichen Resistschicht (R) kann, je nach gewünschtem Anwendungszweck, in breiten Grenzen variiert werden und liegt im allgemeinen im Bereich von 0,1 µm, vorzugsweise von etwa 0,5 µm bis einigen mm, vorzugsweise bis zu etwa 1 mm. Für die Herstellung von Ätz- oder Galvano-Resistschichten, beispielsweise für die Herstellung von Leiterplatten, gedruckten Schaltungen, Dünnschichtschaltungen etc., liegt die Dicke der lichtempfindlichen Resistschicht (R) im allgemeinen im Bereich von 0,1 bis 100 µm. Für den Einsatz zur Herstellung von permanenten Schutz- oder Isolierschichten, insbesondere Lötstoppmasken, werden im allgemeinen dickere Resistschichten herangezogen, deren Gesamtschichtdicke bis etwa 1 oder 2 mm betragen kann. Das Verhältnis der Dicke der oberen Lage (OL) zu der Dicke der unteren Lage (UL) liegt dabei im allgemeinen im Bereich von 1:10 bis 10:1, vorzugsweise im Bereich von 1:5 bis 2:1.

Bevorzugt werden die erfindungsgemäßen, mehrlagigen lichtempfindlichen Resistschichten (R) in Form von Trockenfilmresisten eingesetzt. Hierzu wird die lichtempfindliche Resistschicht (R) mit der freien Oberfläche der oberen Lage (OL) auf einen temporären Schichtträger (T) aufgebracht und auf der gegenüberliegenden Oberfläche, d.h. also auf der freien Oberfläche der unteren Lage (UL) vorzugsweise mit einer Deck- und Schutzschicht (D) versehen. Ein solcher Trockenfilmresist mit einer erfindungsgemäßen, mehrlagigen lichtempfindlichen Resistschicht (R) kann nach den aus dem Stand der Technik an sich bekannten und üblichen Verfahrenstechniken hergestellt werden. So ist es beispielsweise möglich, zunächst die obere Lage (OL) der lichtempfindlichen Resistschicht (R) beispielsweise aus Lösung auf den temporären Schichtträger (T) aufzubringen und getrennt hiervon die untere Lage (UL) der lichtempfindlichen Resistschicht (R) beispielsweise durch Gießen einer entsprechenden Lösung auf die Deckschicht (D) herzustellen. Anschließend werden die freien Oberflächen der oberen bzw. unteren Lage der so hergestellten Teilverbundelemente unter Anwendung von Druck sowie gegebenenfalls Wärme miteinander verbunden. Es ist aber beispielsweise auch möglich, auf den temporären Schichtträger (T) zunächst die obere Lage (OL) der lichtempfindlichen Resistschicht (R) nach einer der bekannten Auftragstechniken aufzubringen, dann auf diese obere Lage (OL) die untere Lage (UL) der lichtempfindlichen Resistschicht (R) aufzubringen, wozu ebenfalls die bekannten Auftragstechniken, wie beispielsweise Gießen aus Lösung, Aufpressen oder Auflaminieren in Betracht kommen, und den so erhaltenen Trockenfilmresist

auf der freien Oberfläche der unteren Lage (UL) gegebenenfalls mit einer Deckschicht (D) zu versehen.

Als Schichtträger (T) für die Herstellung der Trockenfilmresiste kommen die hierfür üblichen, dimensionsstabilen Trägermaterialien, insbesondere Kunststoff-Folien, beispielsweise aus Polyethylenterephthalat oder Polybutylenterephthalat, in Betracht. Die von der lichtempfindlichen Resistschicht (R) leicht abziehbare Deckschicht (D) besteht im allgemeinen aus einem Polyolefin, z.B. Polyethylen oder Polypropylen, oder anderen geeigneten Polymerfilmen, wie sie für solche Deckschichten bekannt und üblich sind.

Zur Durchführung des erfindungsgemäßen Verfahrens zur Herstellung der bildmäßig strukturierten Resistschichten wird die erfindungsgemäße, mehrlagige lichtempfindliche Resistschicht (R) zunächst auf das Substrat aufgebracht, das bildmäßig modifiziert bzw. durch eine bildmäßig strukturierte Resistschicht permanent geschützt werden soll. Die Art des Substrates richtet sich dabei bekanntermaßen nach dem jeweiligen Anwendungszweck der herzustellenden bildmäßig strukturierten Resistschichten. So werden beispielsweise für die Herstellung von Ätz- oder Galvano-Resisten als Substrate Kupferbleche oder kupferkaschierte Basismaterialien verwendet. Für die Herstellung von Dünnschichtschaltungen werden insbesondere Keramiksubstrate, die mit metallischen oder metalloxidischen Schichten beschichtet sind, oder Halbleiterelemente verarbeitet. In der Halbleitertechnik dienen als Substrat häufig Silizium-, GaAs- oder InSb-Scheiben, die oberflächlich mit einer Oxid- oder allgemeinen Isolierschicht versehen sein können. Für die Herstellung von permanenten bildmäßig strukturierten Schutz- oder Isolierschichten, insbesondere Lötstoppmasken, wird die lichtempfindliche Resistschicht z.B. auf das Schaltbild einer gedruckten Schaltung oder eine mit Bohrlöchern versehene Leiterplatte aufgebracht. Das Aufbringen der lichtempfindlichen Resistschicht (R) auf das Substrat kann derart geschehen, daß die einzelnen Lagen (L) der lichtempfindlichen Resistschicht (R) nacheinander auf das Substrat aufgebracht werden; vorteilhafterweise geht man jedoch von der vorgefertigten, mehrlagigen lichtempfindlichen Resistschicht (R), insbesondere in Form eines Trockenfilmresistes, aus und verbindet die freie Oberfläche der unteren Lage (UL) - bei Einsatz eines Trockenfilmresistes nach dem Abziehen einer gegebenenfalls vorhandenen Deckschicht (D) - durch Einwirkung von Druck und gegebenenfalls Wärme in üblicher und bekannter Weise mit der Substratoberfläche.

Nach dem Aufbringen der lichtempfindlichen Resistschicht (R) auf das Substrat wird die lichtempfindliche Resistschicht (R) zur Erzeugung der ge-

wünschten bildmäßigen Strukturierung bildmäßig mit aktinischem Licht, vorzugsweise im Wellenlängenbereich von 220 bis 600 nm, insbesondere im Wellenlängenbereich von 300 bis 420 nm, belichtet.

Die bildmäßige Belichtung der Resistschicht (R) kann dabei durch eine photographische Bildvorlage mit geeigneten Lichtquellen, die aktinisches Licht in dem genannten Wellenlängenbereich emittieren, vorgenommen werden. Als Lichtquellen kommen hierbei z.B. Kohlenbogenlampen, Quecksilberhochdrucklampen, Xenonhochdrucklampen, superaktinische Leuchtstoffröhren und insbesondere Quecksilberniederdruckfluoreszenzlampen in Betracht. Die bildmäßige Belichtung kann auch mit einem bildmäßig modulierten Laserstrahl, z.B. einem UV-Laser, erfolgen. Die Dauer für die bildmäßige Belichtung hängt neben der Zusammensetzung der lichtempfindlichen Resistschicht (R) von der Schichtdicke der oberen Lage (OL) der Resistschicht (R) und der Strahlungsintensität ab. Die Belichtungsdauer wird dabei so gewählt, daß die belichteten Bereiche der oberen Lage (OL) der Resistschicht (R) in dem Entwicklerlösungsmittel hinreichend löslich bzw. dispergierbar werden und somit problemlos ausgewaschen werden können. Die Dauer für diese Belichtung kann dabei in bekannter Weise anhand von einfachen Vorversuchen leicht festgestellt werden. Der Aufbau der unteren Lage (UL) der Resistschicht (R) ist dabei so gewählt, daß auch die untere Lage (UL) bei der gegebenen Dicke der oberen Lage (OL) nach der gegebenen Belichtungsdauer in dem für das Auswaschen der Resistschicht verwendeten Entwicklerlösungsmittel löslich oder dispergierbar ist.

Nach der bildmäßigen Belichtung der Resistschicht (R) werden die belichteten Schichtanteile mit einem geeigneten Entwicklerlösungsmittel in üblicher Weise, beispielsweise durch Besprühen, Ausreiben oder Ausbürsten, ausgewaschen. Als Entwicklerlösungsmittel kommen dabei im allgemeinen wäßrige Medien, insbesondere wäßrig-alkalische Medien, in Betracht, die zur Einstellung des günstigsten pH-Wertes alkalisch reagierende Substanzen, wie z.B. Borax, Dinatriumhydrogenphosphat, Soda oder Alkalihydroxide, oder organische Basen, wie Di- oder Triethanolamin, enthalten. Die Entwicklerlösungsmittel können ferner übliche Puffersubstanzen oder auch Zusätze von oberflächenaktiven Substanzen, wie z.B. Natriumcarboxymethylzellulose, Polyvinylalkohol, Polynatriumacrylat und dgl., enthalten. Ferner ist es möglich, wenn die wäßrigen, insbesondere wäßrig-alkalischen, Entwicklerlösungsmittel auch Zusätze von wasserlöslichen, organischen Lösungsmitteln, wie z.B. aliphatischen Alkoholen, Aceton oder Tetrahydrofuran, enthalten. Die geeigneten Entwicklerlösungsmittel für die jeweils eingesetzten lichtempfindlichen Resistmaterialien sind dem Fachmann bekannt bzw. der einschlägigen Literatur zu entnehmen.

Nach dem Auswaschen wird die erhaltene bildmäßig strukturierte Resistschicht im allgemeinen zur Entfernung von Resten des Entwicklerlösungsmittels getrocknet. Der Vorgang der bildmäßigen Belichtung und des Auswaschens der lichtempfindlichen Resistschicht (R) kann gewünschtenfalls mehrmals wiederholt werden, wobei nach jedem Auswasch- und gegebenenfalls Trocknungsschritt die freigelegten Bereiche des Substrats z.B. durch Platinieren, Ätzen oder Dotieren modifiziert werden können. Je nach eingesetzten lichtempfindlichen Resistmaterialien können die so erhaltenen bildmäßig strukturierten Resistschichten - bei mehrmaliger bildmäßiger Belichtung und Entwicklung nach dem letzten Belichtungs- und Entwicklungsschritt - anschließend durch Erhitzen, vorzugsweise auf Temperaturen über 50°C, insbesondere auf Temperaturen im Bereich von 80°C bis 150°C, und/oder durch vollflächiges Belichten mit aktinischem Licht vernetzt und gehärtet werden. Diese Verfahrensvariante bietet sich insbesondere bei den lichtempfindlichen Resistmaterialien auf Basis von o-Nitrocarbinolestergruppierungen der allgemeinen Formel (I) enthaltenden Verbindungen, insbesondere entsprechenden Polymeren, an, die entweder in den die o-Nitrocarbinolestergruppierungen der allgemeinen Formel (I) tragenden Polymeren weitere funktionelle reaktive Gruppen einpolymerisiert enthalten, oder die vernetzend wirkende Verbindungen als Zusatzstoffe enthalten, die mit den bei der Belichtung erzeugten freien Carboxylgruppen oder den weiteren in den Polymeren der lichtempfindlichen Materialien eingebauten funktionellen Gruppen unter dem Einfluß von Wärme unter Vernetzung zu reagieren vermögen. Wie in der DE-A-32 31 147, der DE-A-33 26 036 und der DE-A-33 31 691 beschrieben ist, kann dabei in Abhängigkeit von den verwendeten lichtempfindlichen Resistmaterialien für die Härtung und Vernetzung allein ein Erhitzen auf hinreichend hohe Temperaturen hinreichend sein, es kann jedoch auch erforderlich sein, daß zur Erzeugung von freien Carboxylgruppen und somit einer hinreichenden Anzahl von vernetzend wirkenden Gruppen, zunächst eine vollflächige Belichtung mit aktinischem Licht vor dem Erhitzen notwendig ist. Ebenso ist es möglich, daß das Härten und Vernetzen allein durch eine nachträgliche vollflächige Belichtung der bildmäßig strukturierten Resistschicht (R) mit aktinischem Licht erfolgt, wenn nämlich die Vernetzungsreaktion der so erzeugten freien Carboxylgruppen mit den anderen in den lichtempfindlichen Resistmaterialien enthaltenen vernetzend wirkenden Verbindungen bereits in hinreichender Geschwindigkeit bei Raumtemperatur abläuft.

Die mit den erfindungsgemäßen, mehrlagigen lichtempfindlichen Resistschichten (R) nach dem beschriebenen Verfahren hergestellten bildmäßig strukturierten Resistschichten eignen sich für alle Anwendungszwecke, die für solche bildmäßig strukturierten Resistschichten bekannt sind, wie z.B. als Ätz- und Galvanoresist in der Herstellung von Leiterbahnen, gedruckten Schaltungen, Halbleiterelementen, elektronischen Bauelementen, Dünnschichtschaltungen, Mehrschichtschaltungen etc. In diesen Fällen wird die durch das Belichten und Auswaschen der Resistschicht entsprechend einer Bildvorlage freigelegte Oberfläche des Substrats anschließend beispielsweise durch Metallabscheidung oder durch Ätzen dauerhaft modifiziert und anschließend die bildmäßig strukturierte Resistschicht durch Strippen mit einem geeigneten Entwicklerlösungsmittel entfernt. Die erfindungsgemäß hergestellten bildmäßig strukturierten Resistschichten eignen sich aber auch als permanente Schutz- bzw. Isolierschichten, insbesondere Lötstoppmasken. In diesem Fall verbleibt die bildmäßig strukturierte Resistschicht auf dem Substrat erhalten.

Ein besonderer Vorteil der erfindungsgemäßen, mehrlagigen, lichtempfindlichen Resistschichten (R) besteht nicht nur darin, daß sie im Vergleich zu einlagigen Resistschichten gleicher Gesamtdicke erheblich kürzere Belichtungszeiten benötigen, sondern sie erlauben insbesondere auch das problemlose Herstellen von bildmäßig strukturierten Resistschichten auf beispielsweise mit Bohrlöchern versehenen Substraten, wie z.B. gebohrten Platinen für Leiterplatten oder den Schaltbildern für gedruckte Schaltungen, wie sie bei der Herstellung von Lötstoppmasken zum Einsatz gelangen. Beim Auflaminieren der lichtempfindlichen Resistschicht (R) auf solche mit Bohrlöchern versehenen Substrate wird nämlich das Resistmaterial im allgemeinen in die Bohrlöcher eingedrückt. Das Freilegen der Bohrlöcher durch bildmäßige Belichtung und Entwicklung ist dabei immer besonders kritisch, da bei den bisher bekannten Resistmaterialien besonders lange Belichtungszeiten notwendig sind, um die in den Bohrlöchern befindlichen Resistanteile vollständig auswaschbar zu machen. Dies bewirkt gleichzeitig eine Überbelichtung der anderen Schichtanteile. Dieses Problem wird mit den erfindungsgemäßen mehrlagigen Resistschichten (R) in einfacher Weise gelöst. Selbst bei Einsatz von mit Bohrlöchern versehenen Substraten, wie sie insbesondere bei der Herstellung von Leiterplatten oder auch Lötstopmasken zur Anwendung kommen, können mit den erfindungsgemäßen lichtempfindlichen Resistschichten (R) kurze Belichtungszeiten eingehalten werden und werden auch die Resistanteile, die sich in die Bohrlöcher eingedrückt haben, vollständig und leicht mit dem Entwicklerlösungsmittel ausgewaschen. Die erfindungsgemäßen Resistschichten und das erfindungsgemäße Verfahren sind darüber hinaus wegen ihrer großen Variabilität besonders vorteilhaft. Durch geeignete Wahl der Materialien für die obere Lage (OL) und die untere Lage (UL) sowie die Verfahrensführung läßt sich in einfacher und leichter Weise eine Anpassung der bildmäßig strukturierten Resistschichten an die je nach Anwendungszweck notwendigen Erfordernisse erzielen.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

a) Es wurde eine Lösung folgender Zusammensetzung hergestellt: 70 Teile eines Copolymerisats aus 35 % o-Nitro-α-methylbenzylacrylat, 1,3 % Acrylsäure und 63,7 % Methylmethacrylat, 29 Teile eines Polyesters aus Adipinsäure und Butandiol (Viskosität 7000 cP bei 20°C), 0,8 Teile Dibrombernsteinsäure, 0,15 Teile des Polymethinfarbstoffs der Formel (II)

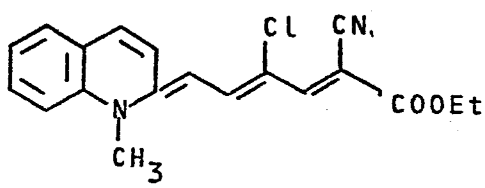

(II)

0,05 Teile Sudantiefschwarz B und 200 Teile Essigester. Die Lösung wurde nach Filtration durch ein 1,5 µm-Filter mit Hilfe einer Rakel auf eine 23 µm dicke, thermofixierte Polyethylenterephthalatfolie gleichmäßig aufgetragen, so daß nach der Trocknung eine 12,5 µm dicke Schicht resultierte. Diese Schicht stellte die obere Lage der gesamten Resistschicht dar.

b) Es wurde eine Lösung folgender Zusammensetzung hergestellt: 70 Teile eines Copolymeren aus 35 % o-Nitro-α-methylbenzylacrylat, 1,6 % Acrylsäure und 63,4 % Methylmethacrylat, 29 Teile eines Polyesters aus Adipinsäure und Butandiol (Viskosität 7000 cP bei 20°C), 0,8 Teile Dibrombernsteinsäure, 0,15 Teile des Polymethinfarbstoffes der oben angegebenen Formel (II), 0,05 Teile Sudantiefschwarz B und 200 Teile Essigester. In gleicher Weise wie unter a) beschrieben, wurde aus dieser Lösung ein 12,5 µm dicker lichtempfindlicher Film hergestellt.

c) Auf ein kupferkaschiertes Substrat, wie es für die Herstellung von Leiterplatten verwendet wird, wurden bei 120°C mit einer Geschwindigkeit von 1 m/min aufeinander die nach b) hergestellte Schicht sowie danach nach Abziehen der Polyethylenterephthalatfolie die nach a) hergestellte Schicht auflaminiert. Die so erhaltene mehrlagige Resistschicht wurde durch eine photographische Positiv-Vorlage 1 Min. mit einem 5000 W-Flachbelichter bildmäßig belichtet. Die belichteten

Schichtanteile wurden mit einem Gemisch aus 85 % Wasser, 12 % 2-Butoxyethanol und 3 % Triethanolamin 10 Min. lang ausgewaschen. Man erhielt ein vorlagengetreues, scharfkantiges Resistmuster, welches durch Abblasen mit Druckluft von Resten des Entwicklerlösungsmittels befreit wurde. Die erhaltene bildmäßig strukturierte Resistschicht gab Bildelemente mit einer Auflösung von 30 µm vorlagengetreu wieder und war in handelsüblichen Ätz- und Galvanikbädern hervorragend beständig.

Vergleichsversuch A

Aus der gleichen Lösung, wie in Beispiel 1a) beschrieben, wurde eine einlagige Resistschicht als 25 µm dicker Film hergestellt. Hiermit wurde entsprechend der Verfahrensweise von Beispiel 1c) ein Resistmuster hergestellt. Um die gleichen Eigenschaften der bildmäßig strukturierten Resistschicht wie in Beispiel 1 zu erhalten, war eine Belichtungszeit von 1,75 Min. notwendig.

Beispiel 2

Es wurden Lösungen folgender Zusammensetzung hergestellt:

a) Schicht OL

| | | |
|---|---|---|
| 70 | Teile Copolymer aus | 45 % o-Nitro-α-methylbenzylacrylat |
| | | 1,3 % Acrylsäure |
| | | 53,7 % Methylmethacrylat |
| 29 | Teile Polyester aus Beispiel 1 | |
| 0,8 | Teile Dibrombernsteinsäure | |
| 0,15 | Teile Polymethinfarbstoff aus Beispiel 1 | |
| 0,05 | Teile Sudantiefschwarz | |
| 200 | Teile Essigester | |

b) Schicht UL

| | | |
|---|---|---|
| 70 | Teile Copolymer aus | 25 % o-Nitro-α-methylbenzylacrylat |
| | | 1,6 % Acrylsäure |
| | | 73,4 % Methylmethacrylat |
| 29 | Teile Polyester aus Beispiel 1 | |
| 0,8 | Teile Dibrombernsteinsäure | |
| 0,15 | Teile Polymethinfarbstoff aus Beispiel 1 | |
| 0,05 | Teile Sudantiefschwarz | |
| 200 | Teile Essigester | |

c) Beide Schichten wurden wie in Beispiel 1 zu 12,5 µm dicken Folien gegossen und Schicht OL auf Schicht UL laminiert. Es wurde verfahren wie in Beispiel 1, mit dem Unterschied, daß die Belichtungszeit 45 Sekunden dauerte. Die Eigenschaften des entwickelten Resists waren identisch mit denen aus Beispiel 1.

Beispiel 3

(Verwendung als Lötstoppfolie)

a) Schicht OL

Man stellte eine Lösung folgender Zusammensetzung her:

| | | |
|---|---|---|
| 55 | Teile Copolymer aus | 30 % o-Nitro-α-methylbenzylacrylat |
| | | 10 % Hydroxypropylacrylat |
| | | 0,5 % Acrylsäure |
| | | 59,5 % Methylmethacrylat |
| 12 | Teile IPDI-Addukt B 1370 (Fa. Veba) | |
| 50 | Teile flüssiger Polyester aus Beispiel 1 | |
| 1 | Teil Dibrombernsteinsäure | |
| 0,02 | Teile Polymethinfarbstoff aus Beispiel 1 | |
| 5 | Teile Aerosil 200 (Fa. Degussa) | |
| 0,01 | Teile Sudantiefschwarz BB | |
| 200 | Teile Essigester | |

b) Schicht UL

| | | |
|---|---|---|
| 50 | Teile Copolymer aus | 10 % o-Nitro-α-methylbenzylacrylat |
| | | 30 % Hydroxypropylacrylat |
| | | 1,3 % Acrylsäure |
| | | 58,7 % Methylmethacrylat |
| 30 | Teile IPDI-Addukt B 1370 (Fa. Veba) | |
| 20 | Teile flüssiger Polyester aus Beispiel 1 | |
| 1 | Teil Dibrombernsteinsäure | |
| 0,02 | Teile Polymethinfarbstoff aus Beispiel 1 | |
| 3 | Teile Aerosil 200 (Fa. Degussa) | |
| 0,01 | Teile Sudantiefschwarz BB | |
| 200 | Teile Essigester | |

Beide Lösungen wurden auf eine Polyethylenterephthalatfolie zu Schichten mit 25 µm Dicke gegossen.

c) Auf eine gedruckte Schaltung wurde Schicht UL und darauf nach Abziehen der Trägerfolie Schicht OL bei 120°C und 0,5 m/min laminiert und 2 Min. durch eine photographische Positiv-Vorlage mit einem 5000 W-Flachbelichter bildmäßig belichtet. Die belichteten, entfärbten Schichtanteile wurden mit einem Gemisch aus 85 % Wasser, 12 % Butoxiethanol und 3 % Triethanolamin 20 Min. lang ausgewaschen. Das so erhaltene vorlagengetreue und scharfkantige Resistmuster wurde durch Abblasen mit Druckluft von Resten des Entwicklerlösungsmittels befreit und anschließend 2 Stunden in einem Umluftofen bei 150°C gehärtet. Der erhaltene Resist hatte eine sehr hohe thermische Beständigkeit, eine ausgezeichnete Haftung auf der als Träger dienenden gedruckten Schaltung und zeigte selbst feine Bildelemente vorlagengetreu und mit scharfen Konturen. In den Bohrlöchern konnten keine Reste von nicht ausgewaschenem Resist entdeckt werden. Die erhaltene Schicht war zur Verwendung als Lötstoppmaske hervorragend geeignet.

Vergleichsversuch B

Eine Lösung folgender Zusammensetzung wurde hergestellt:

| | | | |
|---|---|---|---|
| 50 | Teile Copolymer aus | 20 | % o-Nitro-α-methylbenzylacrylat |
| | | 10 | % Hydroxypropylacrylat |
| | | 0,7 | % Acrylsäure |
| | | 69,3 | % Methylmethacrylat |
| 12 | Teile IPDI-Addukt B 1370 | | |
| 60 | Teile flüssiger Polyester aus Beispiel 1 | | |
| 1 | Teile Dibrombernsteinsäure | | |
| 0,02 | Teile Polymethinfarbstoff aus Beispiel 1 | | |
| 0,01 | Teile Sudantiefschwarz BB | | |
| 4 | Teile Aerosil 200 | | |
| 200 | Teile Essigester | | |

Aus dieser Lösung wurde eine 50 µm dicke Schicht auf eine Polyethylenterephthalatfolie gegossen. Die Schicht wurde auf eine gedruckte Schaltung laminiert, 4 Min. durch eine photographische Positiv-Vorlage belichtet und wie in Beispiel 3 ausgewaschen und gehärtet. In den Bohrlöchern fanden sich noch Resistreste, die beim Löten zu nicht einwandfreien Verbindungen mit elektrischen Bauelementen führten.

Beispiel 4

(Verwendung einer total löslichen unteren Lage UL)

a) Schicht OL

| | | |
|---|---|---|
| 55 | Teile Copolymer aus | 35 % o-Nitro-α-methylbenzylacrylat |
| | | 10 % Hydroxypropylacrylat |
| | | 0,5 % Acrylsäure |
| | | 54,5 % Methylmethacrylat |
| 12 | Teile IPDI-Addukt B 1370 | |
| 40 | Teile Polyester aus Beispiel 1 | |
| 1 | Teil Dibrombernsteinsäure | |
| 0,02 | Teile Polymethinfarbstoff aus Beispiel 1 | |
| 0,01 | Teile Sudantiefschwarz BB | |
| 4 | Teile Aerosil 200 | |
| 200 | Teile Essigester | |

b) Schicht UL

| | | |
|---|---|---|
| 55 | Teile Copolymer aus | 30 % o-Nitro-α-methylbenzylacrylat |
| | | 2 % Acrylsäure |
| | | 68 % Methylmethacrylat |
| 30 | Teile IPDI-Addukt B 1370 | |
| 40 | Teile Polyester aus Beispiel 1 | |
| 1 | Teil Dibrombernsteinsäure | |
| 0,02 | Teile Polymethinfarbstoff aus Beispiel 1 | |
| 0,01 | Teile Sudantiefschwarz BB | |
| 3 | Teile Aerosil 200 | |
| 200 | Teile Essigester | |

Auf eine gedruckte Schaltung wurden folgende Schichtdicken der einzelnen Schichten übereinander laminiert:

| Versuch | Schicht UL | Schicht OL | Belichtungszeit |
|---|---|---|---|
| 4.1 | 25 µm | 25 µm | 1,5 Min. |
| 4.2 | 50 µm | 25 µm | 1,5 Min. |
| 4.3 | 75 µm | 25 µm | 1,5 Min. |
| 4.4 | 35 µm | 15 µm | 1 Min. |
| 4.5 | 60 µm | 15 µm | 1 Min. |
| 4.6 | 85 µm | 15 µm | 1 Min. |

Die Belichtungszeiten wurden, wie aus der Tabelle ersichtlich, nur durch die Dicke der Oberschicht bestimmt. Anschließend wurde, wie in Beispiel 3 beschrieben, ausgewaschen und gehärtet. In allen Fällen enthielt man Schichten, die als Lötstoppmasken hervorragend geeignet waren und keinerlei Resistreste in den Bohrlöchern aufwiesen.

Beispiel 5

Die Lösungen a) und b) aus Beispiel 2 wurden aufkonzentriert, so daß sie 50 %ig in Essigester vorlagen. Dann wurde mit Hilfe eines Rakels Lösung a) auf eine thermofixierte Polyethylenterephthalatfolie gegossen, so daß eine Trockendicke von 12,5 µm entstand und diese Schicht getrocknet. Anschließend wurde Lösung b) darauf gegossen und getrocknet, so daß eine Gesamtdicke von 25 µm resultierte. Die Schicht wurde verarbeitet wie in Beispiel 1 beschrieben, mit dem Unterschied, daß die Belichtungszeit 45 Sekunden betrug. Das erhaltene Bild hatte eine Auflösung von 30 µm und war in handelsüblichen Ätz- und Galvanikbädern hervorragend beständig.

Beispiel 6

Die Lösungen aus Beispiel 5 wurden in einem Arbeitsgang mit Hilfe eines Doppelgießers verarbeitet. Man erhielt einen Resist der gleichen Qualität wie in Beispiel 5.

Beispiel 7
(Unterschiedliche Schichtdicken der einzelnen Lagen)

Aus den Lösungen des Beispiels 2 wurden Resiste mit folgenden Dicken hergestellt:

| Versuch | Schicht OL | Schicht UL | Belichtungszeit |
|---|---|---|---|
| 7.1 | 12,5 µm | 12,5 µm | 45 Sekunden |
| 7.2 | 10 µm | 15 µm | 40 Sekunden |
| 7.3 | 5 µm | 20 µm | 30 Sekunden |

Die Versuche 7.1 und 7.2 ergaben Resiste mit einer Auflösung von 30 µm, Versuch 7.3 einen Resist mit einer Auflösung von 50 µm. Alle 3 erhaltenen Resiste waren in Ätz- und Galvanikbädern beständig.

Patentansprüche

1. Verfahren zur Herstellung von bildmäßig strukturierten Resistschichten auf einem Substrat durch Aufbringen einer positiv arbeitenden, durch Bestrahlung mit aktinischem Licht löslich machbaren Resistschicht (R) auf das Substrat, bildmäßiges Belichten der lichtempfindlichen Resistschicht (R) mit aktinischem Licht und Entfernen der belichteten Schichtanteile durch Auswaschen mit einem Entwicklerlösungsmittel, wobei die positiv arbeitende, lichtempfindliche Resistschicht (R) mindestens aus 2, festen, unmittelbar übereinander angeordneten Lagen (L) gebildet wird, dadurch gekennzeichent, daß die Lagen (L) eine unterschiedliche Grundlöslichkeit besitzen und zumindest die - nach dem Aufbringen auf das Substrat - oberste Lage (OL) der lichtempfindlichen Resistschicht (R) aus einem lichtempfindlichen Material besteht, das durch Bestrahlung mit aktinischem Licht in einem Lösungsmittel löslich oder dispergierbar wird, in dem es zuvor unlöslich war, und die - nach dem Aufbringen auf das Substrat - untere Lage (UL) der lichtempfindlichen Resistschicht (R) in dem für das Auswaschen der bildmäßig belichteten Bereiche der Resistschicht (R) verwendeten Entwicklerlösungsmittel eine höhere Grundlöslichkeit aufweist als die obere Lage (OL).

2. Verfahren nach Anspruch 1, dadurch gekennzeichnet, daß nach dem Auswaschen der belichteten Schichtanteile sowie gegebenenfalls Trocknen die erhaltene bildmäßig strukturierte Resistschicht (R) einer thermisch und/oder photochemisch induzierten Härtung und Vernetzung unterworfen wird.

3. Verfahren nach Anspruch 1 oder 2, dadurch gekennzeichnet, daß die untere Lage (UL) der lichtempfindlichen Resistschicht (R) bereits vor der Bestrahlung mit dem aktinischen Licht in dem Entwicklerlösungsmittel löslich oder dispergierbar ist.

4. Verfahren nach Anspruch 3, dadurch gekennzeichnet, daß die untere Lage (UL) der lichtempfindlichen Resistschicht (R) aus einem carboxylgruppenhaltigen Polymeren gebildet wird, welches gegebenenfalls weitere Zusatz- und/oder Hilfsstoffe enthält.

5. Verfahren nach einem der Ansprüche 1 oder 2, dadurch gekennzeichnet, daß die untere Lage (UL) der lichtempfindlichen Resistschicht (R) aus einem positiv arbeitenden, lichtempfindlichen Material gebildet wird,

das nach der Belichtung mit dem aktinischen Licht in dem gleichen Entwicklerlösungsmittel löslich ist wie die obere Lage (OL).

6. Verfahren nach einem der Ansprüche 1 bis 5, dadurch gekennzeichnet, daß die obere Lage (OL) der lichtempfindlichen Resistschicht (R) aus einem an sich bekannten, positiv arbeitenden, lichtempfindlichen Resistmaterial gebildet wird.

7. Verfahren nach Anspruch 6, dadurch gekennzeichnet, daß die obere Lage (OL) aus einem lichtempfindlichen Resistmaterial auf Basis von aromatischen und/oder heteroaromatischen o-Nitrocarbinolestergruppierungen enthaltenden Verbindungen gebildet wird.

8. Verfahren nach einem der Ansprüche 1 bis 7, dadurch gekennzeichnet, daß die obere Lage (OL) und die untere Lage (UL) weitgehend ähnlich zusammengesetzt sind.

9. Verfahren nach einem der Ansprüche 1 bis 8, dadurch gekennzeichnet, daß das Dickenverhältnis der oberen Lage (OL) und der unteren Lage (UL) im Bereich von 1:10 bis 10:1, insbesondere im Bereich von 1:5 bis 2:1, liegt.

10. Trockenfilmresist, insbesondere zur Anwendung bei der Herstellung von bildmäßig strukturierten Ätz- oder Galvanoresisten oder bildmäßig strukturierten, permanenten Schutz- und Isolierschichten, wie Lötstoppmasken, mit einem dimensionsstabilen, temporären Schichtträger (T), einer darauf aufgebrachten, festen, positiv arbeitenden, durch Bestrahlung mit aktinischem Licht löslich machbaren Resistschicht (R) aus mindestens zwei verschiedenen Lagen (L) sowie vorzugsweise einer Deckschicht (D) auf der lichtempfindlichen Resistschicht (R), die von der lichtempfindlichen Resistschicht (R) ohne gleichzeitiges Entfernen des temporären Schichtträgers (T) abziehbar ist, dadurch gekennzeichnet, daß die Lagen (L) der lichtempfindlichen Resistschicht (R) eine unterschiedliche Grundlöslichkeit besitzen, wobei zumindest die dem temporären Schichtträger (T) benachbarte Lage (OL) aus einem lichtempfindlichen Material besteht, welches bei Belichten mit aktinischem Licht in einem Lösungsmittel löslich oder dispergierbar wird, in dem es zuvor unlöslich war, und die nicht mit dem temporären Schichtträger (T) verbundene Lage (UL) der lichtempfindlichen Resistschicht (R) in dem für das Auswaschen der belichteten Resistschicht (R) zu verwendenden Entwicklerlösungsmittel eine höhere Grundlöslichkeit aufweist als die Lage (OL), gegenüber der Deckschicht (D) nur eine geringe Haftung besitzt und auf ein permanent zu modifizierendes oder zu schützendes Substrat unter Anwendung von Druck sowie gegebenenfalls Wärme unter Ausbildung einer guten Haftung zu dem Substrat auflaminiert werden kann.

11. Trockenfilmresist nach Anspruch 10, dadurch gekennzeichnet, daß die Lage (UL) der lichtempfindlichen Resistschicht (R) bereits ohne Belichtung in dem für die Herstellung der bildmäßig strukturierten Resistschichten (R) zu verwendenden Entwicklerlösungsmittel löslich ist.

12. Trockenfilmresist nach Anspruch 10, dadurch gekennzeichnet, daß die Lage (UL) der lichtempfindlichen Resistschicht (R) auch aus einem positiv arbeitenden, lichtempfindlichen Material gebildet wird, das nach der Belichtung mit aktinischem Licht in dem gleichen Entwicklerlösungsmittel löslich wird wie die Lage (OL).

13. Trockenfilmresist nach einem der Ansprüche 10 bis 12, dadurch gekennzeichnet, daß die Lagen (OL) und (UL) der lichtempfindlichen Resistschicht (R) weitgehend ähnlich aufgebaut sind.

14. Trockenfilmresist nach einem der Ansprüche 10 bis 13, dadurch gekennzeichnet, daß das Dickenverhältnis der Lage (OL) zu der Lage (UL) im Bereich von 1:10 bis 10:1, insbesondere 1:5 bis 2:1, liegt.

15. Trockenfilmresist nach einem der Ansprüche 10 bis 14, dadurch gekennzeichnet, daß zumindestens die Lage (OL) der lichtempfindlichen Resistschicht (R) aus einem lichtempfindlichen Resistmaterial auf Basis von aromatischen und/oder heteroaromatischen o-Nitrocarbinolestergruppierungen tragenden Verbindungen aufgebaut ist.